# EUROPÄISCHE PATENTSCHRIFT

(11) **EP 1 630 947 B1**
(45) Veröffentlichungstag und Bekanntmachung des Hinweises auf die Patenterteilung: **01.10.2008**
(21) Anmeldenummer: 05105871.7
(22) Anmeldetag: 30.06.2005
(51) Int. Cl.: H02P 7/285

(54) **Verfahren zur Messung eines Laststromes**
Method for determining the load current
Procédé de détermination du courant de charge

(30) Priorität: 26.08.2004 DE 102004041220
(43) Veröffentlichungstag der Anmeldung: 01.03.2006
(73) Patentinhaber: ROBERT BOSCH GMBH, 70442 Stuttgart (DE)
(72) Erfinder: Koch, Stefan, 77876, Kappelrodeck (DE); Lunghard, Karlheinz, 77830, Buehlertal (DE); Thoelke, Holger, 77855, Achern (DE)

(56) Entgegenhaltungen:
- DE-A1- 4 434 179
- US-A- 5 210 475
- US-A- 5 856 711
- US-A1- 2003 062 861
- US-B1- 6 181 171

## Beschreibung

### Stand der Technik

Die Erfindung betrifft ein Verfahren zur Messung eines Laststromes einer an einem Gleichspannungsnetz in mindestens zwei Stufen betreibbaren Last nach der Gattung des unabhängigen Anspruchs.

Aus der DE 100 44 388 A ist eine Schaltungsanordnung zum Ein- und Ausschalten eines am Bordnetz eines kraftfahrzeugs betreibbaren Gleichstrommotors mit große Motorleistung bekannt, der über einen Halbleiterschalter mit zugeordneter Steuereinheit an das Gleichstromnetz anschließbar ist. Hierbei wird zur thermischen Entlastung des Halbleiterschalters nach dem Abklingen des Einschaltstromes der Halbleiterschalter durch einen Relaiskontakt überbrückt. Eine Erfassung und Überwachung des Motorstroms ist mit der bekannten Anordnung nicht möglich.

Weiterhin ist aus der DE 196 48 710 C eine Schaltungsanordnung bekannt, welche den Elektromotor des Kühlgebläses einer Brennkraftmaschine einerseits über einen Strompfad mit Vorwiderstand und andererseits über einen Strompfad ohne Vorwiderstand direkt mit der Stromversorgung verbindet zur zweistufigen Ansteuerung des Elektromotors mit unterschiedlichen Drehzahlen. Die Umschaltung der Ansteuerung erfolgt durch eine Steuereinheit, welche den Elektromotor über eine der beiden Zuleitungen mit der Spannungsquelle verbindet. Zusätzlich ist in dem Stromkreis mit Vorwiderstand eine Mikrotempcratursicherung angeordnet, welche bei unzulässig hohem Anstieg des Stromes über den Vorwiderstand diesen Stromkreis unterbricht. Die Steuereinheit für die Umschaltung der Strompfade erhält keine Rückmeldung über die jeweilige Höhe des Speisestroms für den Elektromotor.

Die US 2003/0062861 A1 offenbart eine Schaltungsanordnung zum Betrieb eines permanentmagneterregten Elektromotors mit unterschiedlichen Drehzahlen. Die Schaltungsanordnung umfasst einen ersten Schalter, der in einer operativen Verbindung mit dem Elektromotor steht. Ein Widerstand ist in Reihe mit dem ersten Schalter und dem Elektromotor geschaltet. Parallel zu der Reihenschaltung aus erstem Schalter und Widerstand ist ein zweiter Schalter geschaltet, der über eine Pulsweitenmodulation angesteuert wird. Erster und zweiter Schalter erhalten unabhängig voneinander oder in Kombination ihre Steuersignale über eine elektronische Steuereinheit, um den Elektromotor mit unterschiedlichen Geschwindigkeiten zu betreiben. Eine Rückmeldung über die jeweilige Höhe des Speisestroms für den Elektromotor ist auch hier nicht vorgegehen.

Aus der DE 44 34 179 A1 ist eine Schaltungsanordnung zur Überwachung einer Steuerschaltung bekannt, die einen Treibertransistor mit einer induktiven Last aufweist und die einen zweiten Transistor in einem Parallelzweig zur induktiven Last besitzt. Die Schaltungsanordnung ist mit einer zusätzlichen, externen Strommesseinrichtung ausgerüstet, wobei parallel zu dem Treibertransistor ein aus einem Transistor und einem ohmschen Messwiderstand bestehendes Schaltelement angeordnet ist und wobei während eines Test-Zeitpunktes der durch die induktive Last fließende Strom zu der Messeinrichtung umgeleitet wird und an dem Messwiderstand eine Spannung hervorruft, die den ordnungsgemäßen Zustand der Steuerschaltung erkennen lässt.

### Vorteile der Erfindung

Gegenüber dem genannten Stand der Technik weist die Erfindung den Vorteil auf, dass die Messung eines Laststromes einer an einem Gleichspannungsnetz in mindestens zwei Stufen betreibbaren Last selbst bei Betrieb der Last in einer Stufe, in der keine Messeinrichtung zur Verfügung steht, möglich ist. Auf diese Weise können bis auf eine erste Stufe die ansonsten in jeder weiteren Stufe erforderlichen Messeinrichtungen wie Strommessshunts oder Sense-FETs eingespart werden, was zu einer deutlichen Reduzierung des Bauraums und der Kosten führt. Ein lückender Betrieb der Last, d.h. eine kurzzeitige Unterbrechung der Energieversorgung der Last, kann erfindungsgemäß wirkungsvoll und einfach vermieden werden, indem die zweite festlegbare Zeitdauer kleiner ist als die erste festlegbare Zeitdauer, wobei die Steuereinheit den ersten und den wenigstens zweiten Schalter derart ansteuert, dass die erste Stufe nach Aktivierung der zweiten Stufe deaktiviert und vor Deaktivierung der zweiten Stufe wieder aktiviert wird. Kommt als Last beispielsweise ein Kühlgebläsemotor zum Einsatz, so können störende Geräuschentwicklungen unterdrückt werden.

Weiterhin ist es von Vorteil, wenn die Last in der ersten Stufe mit größtmöglichem Nennlaststrom und in der zumindest zweiten Stufe über einen Vorwiderstand mit gegenüber der ersten Stufe reduziertem Nennlaststrom betrieben wird, so dass zur Messung des Laststroms in der zumindest zweiten Stufe der Spannungsabfall über den Vorwiderstand mit Hilfe einer Messeinrichtung gemessen und an die Steuereinheit übergeben wird.

Um eine Blockierung des Kühlgebläsemotors feststellen zu können, wird ein Schwellwert festgelegt und in der Steuereinheit abgespeichert. Überschreitet der gemessene Laststrom den festgelegten und abgespeicherten Schwellwert, so wird das Kühlgebläse deaktiviert, indem die Steuereinheit alle Schalter öffnet. Somit kann in vorteilhafter Weise einer Zerstörung des Kühlgebläsemotors beispielsweise infolge eines blockierenden Gegenstandes entgegengewirkt werden.

Wird der Schwellwert mit Hilfe eines in der Steuereinheit abgelegten Algorithmus auf Grundlage des während eines Wuchtvorgangs des Kühlgebläsemotors gemessenen Nennlaststroms berechnet, und in der Steuereinheit abgespeichert, so gewährleistet dies einen besonders einfachen und effektiven Lernvorgang, da zumindest ein einmaliges Wuchten des Kühlgebläsemotors vor dessen.Einbau erforderlich ist und somit der entsprechende Nennlaststrom ohnehin zur Verfügung steht. Darüber hinaus ist auf diese Weise ein Lernen des Schwellwertes unabhängig von dem Vorwiderstand bzw. dessen Grundtoleranz möglich.

Weitere Vorteile der Erfindung ergeben sich durch die in den abhängigen Ansprüchen angegebenen Merkmale sowie aus der Zeichnung und der nachfolgenden Beschreibung.

### Zeichnung

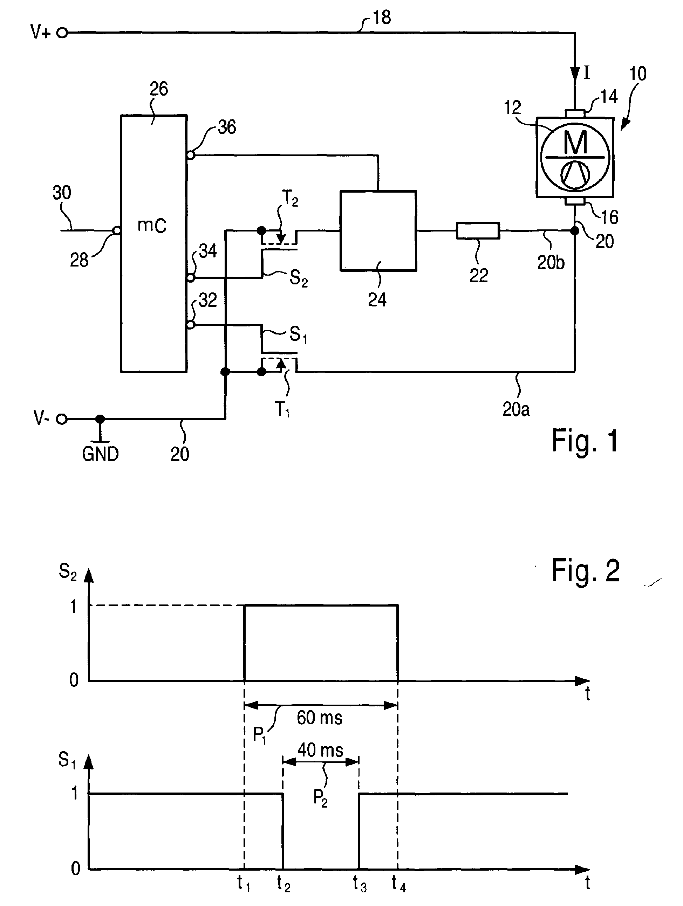

Die Erfindung wird im Folgenden anhand der Figuren 1 und 2 beispielhaft erläutert. Es zeigen
Fig. 1: eine Schaltungsanordnung zur Einstellung und Überwachung der Leistungsaufnahme einer an einem Gleichspannungsnetz in zwei Stufen betriebenen Last, insbesondere eines Kühlgebläsemotors mit zwei Drehzahlstufen und
Fig. 2: Diagramme des zeitlichen Ablaufs einer ersten und einer zweiten Stufe des Kühlgebläsemotors.

### Beschreibung

In Figur 1 ist eine Last 10 als ein permanentmagnetisch erregter Kühlgebläsemotor 12 mit einem ersten Anschluss 14 und einem zweiten Anschluss 16 ausgeführt. Der erste Anschluss 14 des Kühlgebläsemotors 12 ist über eine Leitung 18 mit einem Versorgungspotential V₊ und der zweite Anschluss 16 über Leitungen 20, 20a und 20b mit einem Bezugspotential V- einer nicht gezeigten Gleichstromquelle verbunden. Im Zuge der Leitung 20a liegt ein erster Metal-Oxide-Semiconductor-Field-Effect-Transistor (MOSFET) T₁; im Zuge der Leitung 20b liegen ein Vorwiderstand 22, eine Messeinrichtung 24 und ein zweiter MOSFET T₂. Statt der MOSFET T₁ und T₂ können auch andere Halbleiterschalter - zum Beispiel Bipolar- oder Feldeffekt-Transistoren - oder Relais zum Einsatz kommen. Im dargestellten Ausführungsbeispiel ist die Gleichstromquelle eine Batterie eines Kraftfahrzeugs mit einem Versorgungspotential V₊ von ca. 13V und einem auf Massepotential GND liegenden Bezugspotential V₋. Der die Last 10 bildende Kühlgebläsemotor 12 ist bei der Koppelung mit einem Kühlerlüfter des Kraftfahrzeugs je nach Größe des Kraftfahrzeugmotors für einen Nennlaststrom von etwa 10 bis 50A ausgelegt. Der Kurzschlussstrom eines derartigen Motors im Blockierfall erreicht in etwa den vierfachen Wert des Nennlaststroms. Statt eines Kühlgebläsemotors 12 kann aber auch eine andere elektrische Last 10, beispielsweise ein Stellantrieb, eine Pumpe, eine Lichtquelle oder dergleichen, für eine mehrstufige Ansteuerung in Frage kommen.

Zur Ansteuerung des Kühlgebläsemotors 12 dient eine Steuereinheit 26, beispielsweise in Form eines Mikrocontrollers (µC), welche an einem Eingang 28 ein Steuersignal 30 erhält, das aus mehreren relevanten Kenngrößen für den Kühlungsbedarf des Kraftfahrzeugmotors gebildet wird, insbesondere durch die Kühlmitteltemperatur, die Drehzahl des Kraftfahrzeugmotors und/oder die Fahrzeuggeschwindigkeit sowie durch den Kühlbedarf bei eingeschalteter Klimaanlage.

Im dargestellten Ausführungsbeispiel ist die Motorsteuerung zweistufig ausgelegt, wobei ein erster Ausgang 32 der Steuereinheit 26 der Gate-Elektrode des ersten MOSFET T₁ ein erstes Stufensignal S₁ und ein zweiter Ausgang 34 der Gate-Elektrode des zweiten MOSFET T₂ ein zweites Stufensignal S₂ zuführt. Die beiden MOSFET T₁ und T₂ sind jeweils über ihre Source-Elektroden mit dem Bezugspotential V- bzw. mit dem Massepotential GND verbunden. Zur Bildung der ersten Stufe S₁ besteht eine direkte Verbindung des MOSFET T₁ über seine Drain-Elektrode und die Leitungen 20 und 20a zum zweiten Anschluss 16 des Kühlgebläsemotors 12, so dass beim Schließen des MOSFET T₁ der Kühlgebläsemotor 12 mit dem größtmögliche Nennlaststrom, d.h. mit der größtmöglichen Drehzahl, betrieben wird. Für die zweite Stufe S₂ ist die Drain-Elektrode des zweiten MOSFET T₂ über die Messeinrichtung 24, den Vorwiderstand 22 sowie die Leitungen 20 und 20b mit dem zweiten Anschluss 16 des Kühlgebläsemotors 12 verbunden. Wird demnach der MOSFET T₂ bei geöffnetem MOSFET T₁ geschlossen, so resultiert hieraus ein Erhöhung des sich aus dem Kühlgebläsemotor 12 und dem Vorwiderstand 22 ergebenden Gesamtwiderstands, und der Kühlgebläsemotor 12 wird mit gegenüber der ersten Stufe S₁ reduziertem Nennlaststrom bzw. reduzierter Drehzahl betrieben.

Mittels der Messeinrichtung 24 kann in der zweiten Stufe S₂ ein Spannungsabfall über den Vorwiderstand 22 gemessen und in einen Laststrom I des Kühlgebläsemotors 12 umgerechnet werden. Der gemessene Wert wird dann an den Eingang 36 der Steuereinheit 26 übergeben. Statt der Messeinrichtung 24 und dem MOSFET T₂ ist es auch möglich, den Laststrom I mittels eines Sense-FETs direkt zu messen und an die Steuereinheit 26 zu übergeben. Aus Figur 1 ist ersichtlich, dass eine Messung des Laststromes I in der ersten Stufe S₁, d.h. bei größtmöglichem Nennlaststrom bzw. größtmöglicher Drehzahl des Motorkühlgebläses 12, in Ermangelung einer dort vorhandenen Messeinrichtung ohne weiteres nicht möglich ist. Nichtsdestotrotz kann es aber auch in dieser Stufe zu einer Blockierung und damit zu einer Zerstörung des Kühlgebläsemotor 12 kommen. Im Folgenden soll daher anhand Figur 2 das erfindungsgemäße Verfahren zur Messung des Laststroms I erläutert werden, ohne das weitere Messeinrichtungen, beispielsweise in Gestalt von weiteren Sense-FET, in den jeweiligen Stufen erforderlich wären.

In Figur 2 sind die Diagramme des Ablaufs einer ersten und einer zweiten Stufe S₁ und S₂ des Kühlgebläsemotors 12 in Abhängigkeit von der Zeit t aufgetragen. Die Bezugszeichen S₁ und S₂ kennzeichnen neben den Stufen auch die entsprechenden Stufensignale zur Ansteuerung der beiden MOSFET T₁ und T₂ mittels der Steuereinheit 26, wobei der Wert 1 einen geschlossenen, d.h. niederohmigen und der Wert 0 einen geöffneten, d.h. hochohmigen MOSFET symbolisiert. Der Kühlgebläsemotor läuft zunächst in Stufe S₁, d.h. mit größtmöglichem Nennstrom bzw. größtmöglicher Drehzahl, da bis zum Zeitpunkt t₁ der MOSFET T₁ geschlossen und der MOSFET T₂ geöffnet ist. Die Überwachung einer möglichen Blockierung des Kühlgebläsemotors 12 ist jedoch in Ermangelung einer vorhandenen Messeinrichtung in Stufe S₁ bisher nicht möglich. Zum Zeitpunkt t₁ wird nun für eine erste festlegbare Zeitdauer P₁, beispielsweise 60ms, der MOSFET T₂ zusätzlich zum MOSFET T₁ geschlossen. Aufgrund der Parallelschaltung der die beiden Stufen S₁ und S₂ symbolisierenden Stromzweige mit den Leitungen 20a und 20b sowie der extremen Niederohmigkeit der Stufe S₁ nahe null Ohm kommt es beim Schließen des MOSFET T₂ zum Zeitpunkt t₁ in vorteilhafter Weise nicht zu einer Veränderung der Drehzahl des Kühlgebläsemotors 12.

Zum Zeitpunkt t₂, der zum Beispiel 10ms nach dem Zeitpunkt t₁ liegen kann, wird der MOSFET T₁ für eine zweite festlegbare Zeitdauer P₂, beispielsweise 40ms, geöffnet. Innerhalb dieser zweiten Zeitdauer P₂ ist somit nur noch die Stufe S₂ aktiviert, so dass mit Hilfe des Vorwiderstands 22 und der Messeinrichtung 24 der Laststrom I des Kühlgebläsemotors 12 kurzzeitig gemessen und an die Steuereinheit 26 übergeben werden kann. Nach Ablauf der zweiten Zeitdauer P₂ erfolgt ein erneutes Schließen des MOSFET T₁ zum Zeitpunkt t₃, und weitere 10ms später wird zum Zeitpunkt t₄ der MOSFET T₂ erneut geöffnet, so dass wieder ausschließlich die Stufe S₁ aktiviert ist. Aufgrund der sehr geringen ersten und zweiten Zeitdauern P₁ und P₂ läuft der Kühlgebläsemotor infolge seiner eigenen Massenträgheit mit nahezu unveränderter Drehzahl weiter, so dass das erfindungsgemäße Verfahren keine erhöhte Geräuschentwicklung des Kühlgebläsemotors 12 zur Folge hat.

Der soeben beschriebene Messvorgang kann nun in definierten Zeitabständen, zum Beispiel alle 10 Sekunden, wiederholt werden. Auf diese Weise kann im fortlaufenden Betrieb des Kühlgebläsemotors 12 eine Messung des Laststromes I selbst bei Betrieb in einer Stufe vorgenommen werden, in der üblicherweise keine Messeinrichtung 24 oder ein Sense-FET zur Verfügung steht.

Während des Messvorgangs innerhalb der zweiten Zeitdauer P₂ wird der gemessene Laststrom I mit einem festgelegten und in der Steuereinheit 26 abgespeicherten Schwellwert verglichen. Bei Überschreiten des gemessenen Laststroms I über den Schwellwert wird dann von der Steuereinheit 26 eine Blockierung des Kühlgebläsemotors 12 bzw. eine Überlastung der Last 10 festgestellt, was zu einer Ansteuerung der MOSFET T₁ und T₂ im Sinne eines Öffnens führt. Der in der Steuereinheit 26 abgespeicherte Schwellwert entspricht in etwa dem Blockierstrom des Kühlgebläsemotors 12 und kann mit Hilfe eines in der Steuereinheit 26 abgelegten Algorithmus auf Grundlage des während eines Wuchtvorgangs des Kühlgebläsemotors 12 gemessenen Laststroms I berechnet und abgespeichert werden.

Die Zeitspannen zwischen den Zeitpunkten t₁ und t₂ sowie t₃ und t₄ von jeweils 10ms sollen einen lückenden Betrieb, d.h. eine Unterbrechung der Energieversorgung des Kühlgebläsemotors 12 verhindern.

Es sei abschließend noch darauf hingewiesen, dass das gezeigte Ausführungsbeispiel weder auf die Figuren 1 und 2 noch auf die in der Beschreibung genannten Werte, beispielsweise für die erste und die zweite Zeitdauer P₁ und P₂ oder die definierten Zeitabstände beschränkt ist. Weiterhin ist das erfindungsgemäße Verfahren auch auf mehr als die in den Figuren 1 und 2 gezeigten, zwei Stufen anwendbar. In diesem Fall reicht es zur Messung des Laststroms I aus, wenn von der aktuell gewählten Stufe kurzzeitig in diejenige Stufe umgeschaltet wird, die die Messeinrichtung 24 aufweist.

## Patentansprüche

1. Verfahren zur Messung eines Laststromes (I) einer an einem Gleichspannungsnetz in mindestens zwei Stufen (S₁, S₂) betreibbaren Last (10, 12) mit einem ersten (T₁) und wenigstens einem zweiten Schalter (T₂) zum Aktivieren der ersten (S₁) bzw. der zumindest zweiten Stufe (S₂) der Last (10, 12), sowie mit einer Steuereinheit (26) zum Ansteuern der Schalter (T₁, T₂), wobei während der aktivierten ersten Stufe (S₁) in definierten Zeitabständen die Steuereinheit (26) für eine erste festlegbare Zeitdauer (P₁) die zumindest zweite Stufe (S₂) mittels des wenigstens zweiten Schalters (T₂) aktiviert und innerhalb der ersten festlegbaren Zeitdauer (P₁) für eine zweite festlegbare Zeitdauer (P₂) die erste Stufe (S₁) mittels des ersten Schalters (T₁) deaktiviert, **dadurch gekennzeichnet, dass** die zweite festlegbare Zeitdauer (P₂) kleiner als die erste festlegbare Zeitdauer (P₁) ist und dass die Steuereinheit (26) den ersten (T₁) und den wenigstens zweiten Schalter (T₂) derart ansteuert, dass die erste Stufe (S₁) nach Aktivierung der zweiten Stufe (S₂) deaktiviert und vor Deaktivierung der zweiten Stufe (S₂) wieder aktiviert wird.

2. Verfahren nach Anspruch 1, **dadurch gekennzeichnet, dass** zur Messung des Laststroms (I) in der zumindest zweiten Stufe (S₂) der Spannungsabfall über einen Vorwiderstand (22) mit Hilfe einer Messeinrichtung (24) gemessen und an die Steuereinheit (26) übergeben wird.

3. verfahren nach Anspruch 2, **dadurch gekennzeichnet, dass** in der ersten Stufe (S₁) die Last (10, 12) mit größtmöglichem Nennlaststrom und in der zumindest zweiten Stufe (S₂) über den Vorwiderstand (22) mit gegenüber der ersten Stufe (S₁) reduziertem Nennlaststrom betrieben wird.

4. Verfahren nach einem der vorhergehenden Ansprüche, **dadurch gekennzeichnet, dass** die Last (10) ein Kühlgebläsemotor (12) für ein Kraftfahrzeug ist.

5. Verfahren nach Anspruch 4, **dadurch gekennzeichnet, dass** bei Überschreiten des gemessenen Laststroms (I) über einen festgelegten und in der Steuereinheit (26) abgespeicherten Schwellwert eine Blockierung des Kühlgebläsemotors (12) festgestellt wird und die Steuereinheit (26) zur Deaktivierung des Kühlgebläsemotors (12) alle Schalter (T₁, T₂) öffnet.

6. Verfahren nach Anspruch 5, **dadurch gekennzeichnet, dass** der Schwellwert mit Hilfe eines in der Steuereinheit (26) abgelegten Algorithmus auf Grundlage des während eines Wuchtvorgangs des Kühlgebläsemotors (12) gemessenen Nennlaststroms berechnet und in der Steuereinheit (26) abgespeichert wird.

7. Verfahren nach einem der vorhergehenden Ansprüche, **dadurch gekennzeichnet, dass** die Schalter (T₁, T₂) BipolarTransistoren, Feldeffekt-Transisitoren, MOSFET oder Relais sind.

8. Verfahren nach einem der vorhergehenden Ansprüche, **dadurch gekennzeichnet, dass** der wenigstens zweite Schalter (T₂) ein Sense-FET zur direkten Messung des Laststroms (I) ist.

## Claims

1. Method for measuring a load current (I) of a load (10, 12) which can be operated in at least two stages (S₁, S₂) from a DC voltage network, with a first switch (T₁) and at least one second switch (T₂) for activating the first stage (S₁) and the at least second stage (S₂) of the load (10, 12) and with a control unit (26) for driving the switches (T₁, T₂), the control unit (26) using the at least second switch (T₂) at defined intervals of time to activate the at least second stage (S₂) for a first definable period of time (P₁) during the activated first stage (S₁) and using the first switch (T₁) to deactivate the first stage (S₁) for a second definable period of time (P₂) within the first definable period of time (P₁), **characterized in that** the second definable period of time (P₂) is shorter than the first definable period of time (P₁), and **in that** the control unit (26) drives the first switch (T₁) and the at least second switch (T₂) in such a manner that the first stage (S₁) is deactivated after the second stage (S₂) has been activated and is activated again before the second stage (S₂) is deactivated.

2. Method according to Claim 1, **characterized in that,** in order to measure the load current (I) in the at least second stage (S₂), the voltage drop across a series resistor (22) is measured using a measuring device (24) and is passed to the control unit (26).

3. Method according to Claim 2, **characterized in that,** in the first stage (S₁), the load (10, 12) is operated with the greatest possible rated load current and, in the at least second stage (S₂), the load (10, 12) is operated with a rated load current which is reduced in comparison with the first stage (S₁) by means of the series resistor (22).

4. Method according to one of the preceding claims, **characterized in that** the load (10) is a cooling fan motor (12) for a motor vehicle.

5. Method according to Claim 4, **characterized in that,** when the measured load current (I) exceeds a defined threshold value which is stored in the control unit (26), blocking of the cooling fan motor (12) is determined and the control unit (26) opens all switches (T₁, T₂) in order to deactivate the cooling fan motor (12).

6. Method according to Claim 5, **characterized in that** the threshold value is calculated, with the aid of an algorithm stored in the control unit (26), on the basis of the rated load current measured during a balancing operation of the cooling fan motor (12) and is stored in the control unit (26).

7. Method according to one of the preceding claims, **characterized in that** the switches (T₁, T₂) are bipolar transistors, field effect transistors, MOSFETs or relays.

8. Method according to one of the preceding claims, **characterized in that** the at least second switch (T₂) is a sense FET for directly measuring the load current (I).

## Revendications

1. Procédé de mesure d'un courant de charge (I) appliqué à une charge (10, 12) fonctionnant suivant au moins deux niveaux (S1, S2) par un réseau de tension continue, ayant un premier commutateur (T1) et au moins un second commutateur (T2) pour activer le premier niveau (S1) et au moins le second niveau (S2) de la charge (10, 12) ainsi qu'une unité de commande (26) pour commander les commutateurs (T1, T2),
et pendant que le premier niveau (S1) est activé, dans des intervalles de temps défini, l'unité de commande (26) active pendant une première durée fixée (P1), au moins le second niveau (S2) au moins à l'aide du second commutateur (T2) et à l'intérieur d'une première durée fixée (P1) et pendant une seconde durée fixée (P2), le premier niveau (S1) est neutralisé par le premier commutateur (T1),
**caractérisé en ce que**
la seconde durée fixée (P2) est inférieure à la première durée fixée (P1) et l'unité de commande (26) commande le premier commutateur (T1) et au moins le second commutateur (T2) de façon que le premier niveau (S1) soit neutralisé après l'activation du second niveau (S2) et qu'il soit réactivé avant que le second niveau (S2) ne soit neutralisé.

2. Procédé selon la revendication 1,
**caractérisé en ce que**
pour mesurer le courant de charge (I) au moins dans le second niveau (S2), on mesure la chute de tension aux bornes d'une résistance intermédiaire (22) à l'aide d'une installation de mesure (24) et on transmet le résultat à l'unité de commande (26).

3. Procédé selon la revendication 2,
**caractérisé en ce que**
dans le premier niveau (S1), la charge (10, 12) fonctionne avec le courant de charge nominal le plus grand possible et au moins dans le second niveau (S2), le courant de charge, nominal, est réduit par rapport à celui du premier niveau (S1) par la résistance intermédiaire (22).

4. Procédé selon l'une des revendications précédentes,
**caractérisé en ce que**
la charge (10) est un moteur de ventilateur de radiateur (12) d'un véhicule automobile.

5. Procédé selon la revendication 4,
**caractérisé en ce qu'**
en cas de dépassement du courant de charge mesuré (I) par rapport à une valeur de seuil fixée et enregistrée en mémoire dans l'unité de commande (26), on constate un blocage du moteur de ventilateur de radiateur (12) et l'unité de commande (26) ouvre tous les commutateurs (T1, T2) pour neutraliser le moteur du ventilateur de radiateur (12).

6. Procédé selon la revendication 5,
**caractérisé en ce que**
l'on mesure la valeur du seuil à l'aide d'un algorithme enregistré dans l'unité de commande (26) sur le fondement du courant de charge nominal mesuré au cours de l'opération de calibrage du moteur du ventilateur de refroidissement (12) et on l'enregistre en mémoire dans l'unité de commande (26).

7. Procédé selon l'un des revendications précédentes,
**caractérisé en ce que**
les commutateurs (T1, T2) sont des transistors bipolaires, des transistors à effet de champ, des composants MOSFET ou des relais.

8. Procédé selon l'une des revendications précédentes,
**caractérisé en ce qu'**
au moins le second commutateur (T2) est un transistor FET de détection pour la mesure directe du courant de charge (I).
